Europäisches Patentamt

European Patent Office

Office européen des brevets

(19)

(11) Veröffentlichungsnummer: **0 312 528**
**B1**

(12) **EUROPÄISCHE PATENTSCHRIFT**

(45) Veröffentlichungstag der Patentschrift:
28.02.90

(51) Int. Cl.⁵: **H 01 L 25/16, H 01 L 23/52**

(21) Anmeldenummer: 87902435.4

(22) Anmeldetag: 09.05.87

(86) Internationale Anmeldenummer:
PCT/DE 87/00218

(87) Internationale Veröffentlichungsnummer:
WO 88/00396 (14.01.88 Gazette 88/02)

(54) MEHRPLATTEN-HYBRIDGERÄT MIT INTEGRIERTER WÄRMEABLEITUNG.

(30) Priorität: 30.06.86 DE 3621930

(43) Veröffentlichungstag der Anmeldung:
26.04.89 Patentblatt 89/17

(45) Bekanntmachung des Hinweises auf die Patenterteilung:
28.02.90 Patentblatt 90/09

(84) Bennante Vertragsstaaten:
DE FR IT

(56) Entgegenhaltungen:
EP-A-98 932
DE-B-1 490 832
US-A-4 283 754

Und-Oder-NOR + Steurungstechnik, vol.14, no.9, September 1984, Mainz, DE, W.A. BROTHERTON et al.:"Elektronische Hybrid-Systeme", pages 28-30

PATENT Abstracts OF JAPAN, vol8, no.200, (E-266)(1637), 13 September 1984 & JP-A-5987841

(73) Patentinhaber: ROBERT BOSCH GMBH
Postfach 50
D-7000 Stuttgart 1 (DE)

(72) Erfinder: SEIPLER, Dieter
Paul-Hindemith-Str. 1
D-7410 Reutlingen (DE)

LIBERGRAF, STOCKHOLM 1990

# Beschreibung

## Stand der Technik

Die Erfindung betrifft ein Mehrplatten-Hybridgerät nach der Gattung des Hauptanspruchs.

Unter einer Hybridschaltung wird eine Mikro-Schaltungsintegration verstanden, bei der passive Bauelemente wie Widerstände, Kondensatoren, kleine Induktivitäten mit ihren Verdrahtungen als Filmschaltung hergestellt sind und diskrete oder monolitisch integrierte aktive Schaltungseinheiten in diese Filmschaltung eingesetzt sind.

Aus der Zeitschrift "Und-Oder-Nor + Steuerungstechnik", Band 14, Nr. 9, September 1984, Seiten 28 bis 30 ist bereits ein Mehrplatten-Hybridgerät nach der Gattung des Hauptanspruchs bekannt. Die jeweils mit einem Metallrahmen versehenen, übereinander gestapelten Schichthybridsubstrate sind hierbei zum Schutz gegen Beschädigung in ein rohrförmiges Gehäuse eingesetzt. In diesem bekannten Hybridgerät erfolgt die Ableitung der in den verschiedenen Hybridschaltungen des Geräts entstehenden Verlustwärme über das rohrförmige Gehäuse.

## Vorteile der Erfindung

Das erfindungsgemäße Mehrplatten-Hybridgerät mit den Merkmalen des Hauptanspruchs hat demgegenüber den Vorteil, daß die Metallrahmen in ihrer Gesamtheit das Gehäuse des Mehrplatten-Hybridgeräts bilden und auf diese Weise auf ein zusätzliches rohrförmiges Gehäuse, wie es bei dem eingangs erwähnten bekannten gattungsgemäßen Mehrplatten-Hybridgerät vorgesehen ist, verzichtet werden kann. Gleichzeitig wird die Ableitung der Verlustwärme erheblich verbessert. Weitere Vorteile ergeben sich aus den Unteransprüchen 2 bis 9 und aus der Beschreibung.

## Zeichnung

Die Erfindung wird nachfolgend anhand der Zeichnung erläutert. Es zeigen:

Fig. 1 einen teilweise dargestellten Längsschnitt durch ein erfindungsgemäßes Mehrplatten-Hybridgerät mit integrierter Wärmeableitung;

Fig. 2 einen Querschnitt durch das Mehrplatten-Hybridgerät nach Fig. 1 entlang der Linie II - II;

Fig. 3 eine Rückansicht eines Metallgehäuses für das Mehrplatten-Hybridgerät;

Fig. 4 einen Querschnitt durch ein Deckelprofil zum Abdecken der Rückseite des Mehrplatten-Hybridgeräts.

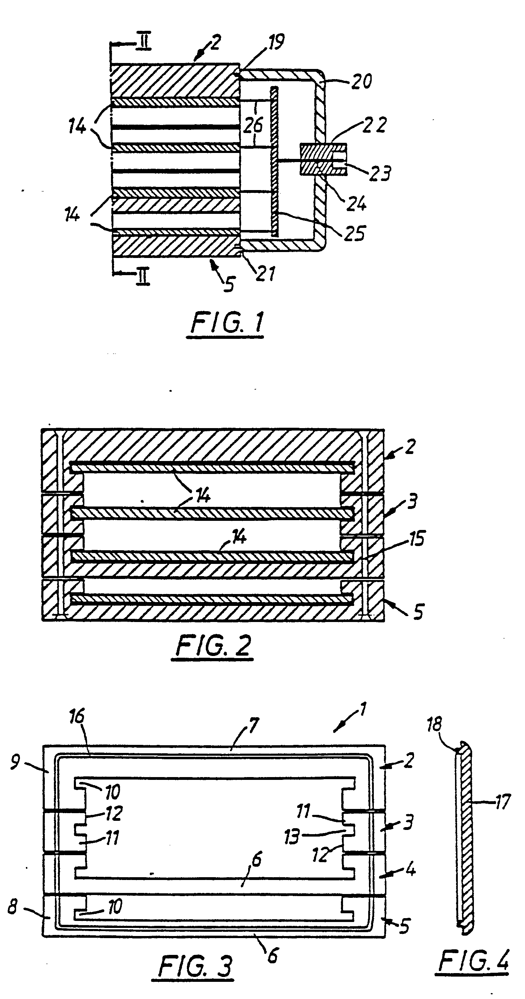

Ein Mehrplatten-Hybridgerät mit integrierter Wärmeableitung weist gemäß den Figuren 1 - 3 ein Metallgehäuse 1 auf, welche aus übereinander gestapelten Metallrahmen 2 - 5 besteht. Im vorliegenden Ausführungsbeispiel ist ein Deckrahmen 2 und ein Bodenrahmen 5 gezeigt, zwischen denen Zwischenträger 3 sowie ein weiterer Zwischenträger 4 mit Wärmeankopplung angeordnet sind.

Deckrahmen 2, Bodenrahmen 5 und Zwischenträger 4 mit Wärmeankopplung weisen querschnittlich eine etwa U-förmige Gestaltung auf, wobei jeweils seitlich von einer Metallplatte 6 bzw. 7 Schenkel 8 bzw. 9 abragen, welche mit der Metallplatte 6 bzw. 7 jeweils sich gegenüberliegende Führungsnuten 10 ausbilden.

Beim Zwischenträger 3 fehlt dagegen eine Metallplatte, vielmehr sind hier zwei sich gegenüberliegende Rahmen 11 vorgesehen, in deren zueinanderweisende Stirnflächen 12 jeweils Führungsnuten 13 eingeformt sind.

Die Führungsnuten 10, 13 dienen der Aufnahme von Dickschichthybridsubstraten 14, wobei ein Dickschichthybridsubstrat durch den Zwischenträger 3 lediglich in den Führungsnuten 13 gehalten wird, während die Dickschichthybridsubstrate 14 in dem Deckrahmen 2 dem Zwischenträger 4 und dem Bodenrahmen 5 dort auch an den Metallplatten 6 bzw. 7 anliegen. Die Dickschichthybridsubstrate 14 können den Metallplatten 6 bzw. 7 aufgeklebt sein, wobei beispielsweise der Metallplatte 6 des Bodenrahmens 5 auch eine Endstufe, beispielsweise eine Transistor- bzw. Halbleiter-Endstufe, oder dergleichen eventuell gleich mit einer Verdeckplatte aufgeklebt wird.

Die Metallrahmen 2 - 5 sind, wie in Figur 2 dargestellt, von Verschraubungskanälen 15 durchzogen, in die nicht näher dargestellte Schraubenbolzen eingesetzt werden, mittels denen die Metallrahmen 2 - 5 zu dem Metallgehäuse 1 zusammengespannt werden.

Die in Figur 3 gezeigte Rückseite des Metallgehäuses 1 ist mit einer Abdichtungsrille 16 versehen, in welche in Gebrauchslage ein einem in Figur 4 gezeigten Deckel 17 angeformter Vorsprung 18 eingreift und eingeklebt ist.

Auch die in Figur 1 gezeigte Vorderseite des Metallgehäuses 1 weist eine Abdichtungsrille 19 auf, in die ein Blendenprofil 20 mit einem Vorsprung 21 eingreift. Das Blendenprofil 20 wird von einem Stecker 22 durchsetzt, in den Kontaktbohrungen 23 eingeformt sind. Die Kontaktbohrung 23 steht über einen Kontaktstift 24 mit einer Verbindungsplatine (Leiterplatte) 25 in Verbindung. In diese Verbindungsplatine 25 münden Anschlußfahnen 26 aus den Dickschichthybridsubstraten 14.

## Patentansprüche

1. Mehrplatten-Hybridgerät mit Schichthybridsubstraten (14), auf denen Hybridschaltungen aufgebaut sind und die in Metallrahmen (2, 3, 4, 5) gehaltert und übereinander gestapelt sind, wobei zur Verbesserung der Wärmeableitung

- die Metallrahmen (2, 3, 4, 5) innerhalb des Stapels derart aneinandergefügt sind, daß sie in ihrer Gesamtheit ein gut wärmeleitendes Metallgehäuse (1) für das Hybridgerät bilden
- mindestens die Metallrahmen (2, 4, 5) derjenigen Schichthybridsubstrate (14), auf denen Hybridschaltungen mit hoher Verlustwärme aufgebaut sind, im Querschnitt derart U-förmig ausgebildet sind, daß sie jeweils eine an dem zugehörigen Schichthybridsubstrat (14) anliegende, die Verlustwärme gut leitende metallische Grundplatte (6, 7) und sich daran anschließende Schenkel (8, 9) bilden, wobei die Schenkel (8, 9) das zugehörige Schichthybridsubstrat (14) unter Ausbildung von Führungsnuten (10) seitlich umgreifen.

2. Mehrplatten-Hybridgerät nach Anspruch 1, dadurch gekennzeichnet, daß das Schichthybridsubstrat (14) auf die zugehörige metallische Grundplatte (6, 7) geklebt ist.

3. Mehrplatten-Hybridgerät nach Anspruch 1 oder 2, dadurch gekennzeichnet, daß mindestens einer (3) der Metallrahmen (2, 3, 4, 5) als Zwischenträger dient derart, daß in dem Stapel mindestens einer der übrigen Rahmen oberhalb und mindestens einer der übrigen Rahmen unterhalb dem als Zwischenträger dienenden Rahmen angeordnet ist, wobei ferner der als Zwischenträger dienende Rahmen (3) an seiner inneren Stirnfläche (12) eine Führungsnut (13) aufweist, in die das zugehörige Schichthybridsubstrat (14) hineinragt.

4. Mehrplatten-Hybridgerät nach einem der Ansprüche 1 bis 3, dadurch gekennzeichnet, daß die übereinander angeordneten Metallrahmen (2, 3, 4, 5) von Verschraubungskanälen (15) durchsetzt sind.

5. Mehrplatten-Hybridgerät nach einem der Ansprüche 1 bis 4, dadurch gekennzeichnet, daß in die von den Metallrahmen (2, 3, 4, 5) gebildete Rück- und Vorderseite des Metallgehäuses (1) je eine Abdichtungsrille (16, 19) eingeformt ist.

6. Mehrplatten-Hybridgerät nach Anspruch 5, dadurch gekennzeichnet, daß in eine (16) der beiden Abdichtungsrillen (16, 19) ein Vorsprung (18) eines Deckels (17) eingreift.

7. Mehrplatten-Hybridgerät nach einem der Ansprüche 1 bis 6, dadurch gekennzeichnet, daß von den Schichthybridsubstraten (14) Anschlußfahnen (26) abragen, welche mittels einer Verbindungsplatine (25 zusammengefaßt sind.

8. Mehrplatten-Hybridgerät nach Anspruch 7, dadurch gekennzeichnet, daß Kontaktstifte (24) eines Steckers (22) in die Verbindungsplatine (25) eingesetzt und über Kontaktbohrungen (23) oder dergleichen von außen zugänglich sind.

9. Mehrplatten-Hybridgerät nach Anspruch 8, dadurch gekennzeichnet, daß der Stecker (22) ein Blendenprofil (20) durchsetzt, welches die Verbindungsplatine (25) überdeckt und mit einem Vorsprung (21) in eine an der Gehäusevorderseite angebrachte Abdichtungsrille (19) eingesetzt ist.

**Claims**

1. Multiple-plate hybrid device comprising hybrid substrate layers (14) on which hybrid circuits are built up and which are mounted in metal frames (2, 3, 4, 5) and are stacked above one another, characterized in that, in order to improve the heat dissipation,

- the metal frames (2, 3, 4, 5) are joined together within the stack in such a manner that, in their totality, they form a metal housing (1) of good thermal conductivity for the hybrid device,
- at least the metal frames (2, 4, 5) of those hybrid substrate layers (14) on which hybrid circuits having a high heat dissipation are built up, are constructed to be U-shaped in cross-section in such a manner that they form in each case a metallic base plate (6, 7) of good conductivity for the heat dissipation, which rests against the associated hybrid substrate layer (14), and adjoining legs (8, 9), the legs (8, 9) laterally encircling the associated hybrid substrate layer (14), forming guide slots (10).

2. Multiple-plate hybrid device according to Claim 1, characterized in that the hybrid substrate layer (14) is bonded to the associated metallic base plate (6, 7).

3. Multiple-plate hybrid device according to Claim 1 or 2, characterized in that at least one (3) of the metal frames (2, 3, 4, 5) is used as intermediate carrier, that at least one of the remaining frames is arranged above and at least one of the remaining frames is arranged below the frame used as intermediate carrier in the stack, the frame (3) used as intermediate carrier furthermore exhibiting at its inner front face (12) a guide slot (13) into which the associated hybrid substrate layer (14) projects.

4. Multiple-plate hybrid device according to one of Claims 1 to 3, characterized in that bolting channels (15) pass through the metal frames (2, 3, 4, 5) which are arranged above one another.

5. Multiple-plate hybrid device according to one of Claims 1 to 4, characterized in that a sealing groove (16, 19) each is moulded into the rear and front of the metal housing (1) formed by the metal frames (2, 3, 4, 5).

6. Multiple-plate hybrid device according to Claim 5, characterized in that a projection (18) of a cover (17) engages one (16) of the two sealing grooves (16, 19).

7. Multiple-plate hybrid device according to one of Claims 1 to 6, characterized in that connecting tabs (26), which are combined by means of a connecting panel (25), extend from the hybrid substrate layers (14).

8. Multiple-plate hybrid device according to Claim 7, characterized in that contact pins (24) of a connector (22) are inserted in the connecting panel (25) and are accessible from the outside via contact holes (23) or the like.

9. Multiple-plate hybrid device according to Claim 8, characterized in that the connector (22) passes through a shield section (20) which covers the connecting panel (25) and is inserted with a projection (21) into a sealing groove (19) provided at the housing front.

**Revendications**

1. Appareil hybride à plaquettes multiples avec des substrats hybrides en couches (14) sur lesquels sont constitués des circuits hybrides et qui sont maintenus dans des cadres métalliques (2, 3, 4, 5) et empilés les uns sur les autres, tandis que pour améliorer l'évacuation de chaleur:

- les cadres métalliques (2, 3, 4, 5)sont joints l'un à l'autre à l'intérieur de l'empilage, de façon qu'ils constituent dans leur ensemble un boîtier métallique (1) bon conducteur thermique, pour l'appareil hybride,
- au moins les cadres métalliques (2, 4, 5) des substrats hybrides à couches (14) sur lesquels sont constitués des circuits hybrides avec des pertes de chaleur élevées ont une section transversale en forme de U de sorte qu'ils comportent respectivement une plaque de base métallique (6, 7) bonne conductrice de la chaleur perdue et des côtés (8, 9) se raccordant à cette plaque, ces côtés (8, 9) enveloppant le substrat hybride à couche correspondante (14) grâce à l'aménagement de rainures de guidage (10).

2. Appareil hybride à plaquettes multiples selon la revendication 1, caractérisé en ce que le substrat hybride à couche (14) est collé sur la plaque de base métallique correspondante (6, 7).

3. Appareil hybride à plaquettes multiples selon la revendication 1 ou 2, caractérisé en ce qu'au moins un (3) des cadres métalliques (2, 3, 4, 5) sert de support intermédiaire, de sorte que dans l'empilage, au moins un des autres cadres est disposé au-dessus du cadre servant de support intermédiaire, tandis qu'au moins un autre cadre est disposé au-dessous; cependant que les éléments de cadre (3) servant de supports intermédiaires, comportent sur leurs faces frontales internes (12) une rainure de guidage (13) dans laquelle pénètre le substrat hybride à couche correspondant (14).

4. Appareil hybride à plaquettes multiples selon une des revendications 1 à 3, caractérisé en ce que les cadres métalliques (2, 3, 4, 5) disposés les uns au-dessus des autres, sont traversés par des canaux de vissage (15).

5. Appareil hybride à plaquettes multiples selon une des revendications 1 à 4, caractérisé en ce que, dans chacune des faces arrière et avant du boîtier métallique (1) constitué par les cadres métalliques (2, 3, 4, 5), est prévue une rainure d'étanchéité (16, 19).

6. Appareil hybride à plaquettes multiples selon la revendication 5, caractérisé en ce que dans une (16) des deux rainures d'étanchéité (16, 19) vient en prise une saillie (18) d'un couvercle (17).

7. Appareil hybride à plaquettes multiples selon une des revendications 1 à 6, caractérisé en ce que des substrats hybrides à couches (14) partent des cosses de raccordement (26) qui sont rassemblées au moyen d'une platine de liaison (25).

8. Appareil hybride à plaquettes multiples selon la revendication 7, caractérisé en ce que des broches de contact (24) d'un contacteur (22) sont mises en place dans la platine de liaison (25) et par l'intermédiaire de perçages de contact (23) ou analogues, sont accessibles de l'extérieur.

9. Appareil hybride à plaquettes multiples selon la revendication 8, caractérisé en ce que le connecteur (22) traverse un obturateur (20) qui recouvre la platine de liaison (25) et qui, avec une saillie (21) est inséré dans une rainure d'étanchéité (19) réalisée sur la face avant du boîtier.

FIG. 1

FIG. 2

FIG. 3

FIG. 4